**Europäisches Patentamt**

**European Patent Office**

**Office européen des brevets**

(19)

(11) Veröffentlichungsnummer: **0 356 887**
**A2**

## (12) EUROPÄISCHE PATENTANMELDUNG

(21) Anmeldenummer: 89115492.4

(22) Anmeldetag: 23.08.89

(51) Int. Cl.⁵: **G02B 6/00**

(30) Priorität: 01.09.88 AU 174/88

(43) Veröffentlichungstag der Anmeldung:
07.03.90 Patentblatt 90/10

(84) Benannte Vertragsstaaten:
AT BE CH DE ES FR GB GR IT LI LU NL SE

(71) Anmelder: **KRONE Aktiengesellschaft**
**Beeskowdamm 3-11**
**D-1000 Berlin 37(DE)**

(72) Erfinder: **Fitzgerald, Robert**
**15 Mossmann Avenue**
**Bateau Bay. N.S.W. 2261(AU)**

(54) **Verfahren zum selektiven Richten elektromagnetischer Strahlung auf eine vorgegebene Stelle eines Gegenstandes.**

(57) Die Erfindung bezieht sich auf ein Verfahren zum selektiven Richten elektromagnetischer Strahlung auf eine vorgegebene Stelle eines Gegenstandes, z. B. einer Leiterplatte. Dieses Verfahren ist bisher nur für 2-dimensionale Gegenstände, insbesondere Leiterplatten, verwendbar.

Um auch Gegenstände mit 3-dimensionaler Oberfläche, z. B. Spritzgußleiterplatten, nach diesem Verfahren bearbeiten zu können, sieht die Erfindung vor, daß die elektromagnetische Strahlung in ein Werkzeug in Form eines Körpers aus im wesentlichen für die elektromagnetische Strahlung transportem Material gestrahlt wird, wobei die Oberfläche des Körpers über einen ersten, benachbart zur besagten Stelle des Gegenstandes angeordneten Bereich im Vergleich zu einem benachbartem, zweiten Bereich der Körperoberfläche verändert wird, wobei die in den Körper gestrahlte elektromagnetische Strahlung selektiv von dem ersten Bereich emitiert wird und an besagter Stelle auf den Gegenstand auftrifft.

# FIG.1

EP 0 356 887 A2

# VERFAHREN ZUM SELEKTIVEN RICHTEN ELEKTROMAGNETISCHER STRAHLUNG AUF EINE VORGEGEBENE STELLE EINES GEGENSTANDS

Die Erfindung bezieht sich auf ein Verfahren zum selektiven Richten elektromagnetischer Strahlung auf eine vorgegebene Stelle eines Gegenstands.

Es gibt Umstände, unter denen es wünschenswert ist, elektromagnetische Strahlung, wie z.B. Licht, selektiv auf die Oberfläche eines Gegenstands zu richten. Insbesondere ist es bei der Herstellung von Leiterplatten üblich, die Leiterplatte mit einer Kupferkaschierung zu versehen, die dann mit einer Schicht von auf Ultraviolettlicht empfindlichem Material überzogen wird. Gewünschte Bereiche der Schicht von auf Ultraviolettlicht empfindlichem Material werden dann mit Ultraviolettlicht von einer geeigneten Quelle belichtet, um die Eigenschaften des Materials dort zu ändern, wo das Licht auffällt. Nach der Belichtung wird die Platte mit einem geeigneten Lösungsmittel zum Abwaschen eines Teils des auf Ultraviolettlicht empfindlichen Materials behandelt, insbesondere von den Bereichen, die entweder dem Ultraviolettlicht ausgesetzt wurden oder die bei dem beschriebenen Belichtungsvorgang nicht beaufschlagt wurden, wodurch derjenige Teil der Schicht entfernt wird, der entweder vom Ultraviolettlicht belichtet wurde oder nicht belichtet wurde. Diese Entfernen wird üblicherweise durch chemisches Ätzen bewirkt. Da die Platten eben sind, bereitet es im allgemeinen keine Schwierigkeiten, ein geeignetes Lichtmuster selektiv auf der Oberfläche vorzusehen, um die Bereiche des darunter befindlichen Kupfers zu definieren, die je nach dem anzuwendenden Vorgang zu entfernen oder beizubehalten sind. Insbesondere ist es üblich, eine geeignete Maske in Form beispielsweise schwarzer und weißer transparenter Bereiche vorzusehen, die das gewünschte Belichtungsmuster darstellen (d.h. die normalerweise die gewünschten Leiterbahnen bilden), und dieses kann auf die Leiterplatte aufgebracht und belichtet oder durch photographische Projektionstechniken auf die Platte projiziert werden.

Obige Technologie ist wohlbekannt und liefert, wie gesagt, zufriedenstellende Ergebnisse bei den im wesentlichen zweidimensionalen Leiterplattenaufbauten, die zur Zeit in allgemeiner Verwendung sind.

Seit kurzem ist jedoch eine Technologie im Entstehen, die Leiterplatten verwendet, die allgemein als sog. "Spritzgußleiterplatten" bezeichnet werden, welche komplexe dreidimensionale Oberflächenformen aufweisen. Bei diesen ist es schwierig, gewünschte Leiterbahnen durch selektive Belichtung im Ätzvorgang zu bilden.

Allgemein gesagt, liefert die Erfindung ein Verfahren zum selektiven Richten elektromagnetischer Strahlung auf eine vorgegebene Stelle eines Gegenstands, wie z.B. einer Leiterplatte, wobei die elektromagnetische Strahlung in ein Werkzeug in Form eines Körpers aus im wesentlichen für die elektromagnetische Strahlung transparentem Material gestrahlt wird, wobei die Oberfläche des Körpers über einen ersten, benachbart zur besagten Stelle angeordneten Bereich im Vergleich zu einem benachbarten, zweiten Bereich der Körperoberfläche verändert wird, wobei die in den Körper gestrahlte elektromagnetische Strahlung selektiv von dem ersten Bereich emittiert wird und an besagter Stelle auf den Gegenstand auftrifft.

In besonderen Ausführungsformen der Erfindung ist der Körper an besagtem ersten Bereich mit einer aufgerauhten Oberfläche ausgebildet.

Der zweite Bereich kann beispielsweise undruchsichtig sein, um den Austritt elektromagnetischer Strahlung zu verhindern, und/oder kann glatt oder poliert und so angeordnet sein, daß die in den Körper eintretende elektromagnetische Strahlung im Innern totalreflektiert wird.

Im folgenden wird die Erfindung beispielhaft unter Bezug auf die beigefügten Zeichnungen beschrieben.

Fig. 1 und 2 sind Diagramme, die das Phänomen der Totalreflexion im Innern darstellen.

Figur 3 ist eine Perspektivansicht eines für die Ausführung der Erfindung nützlichen Werkzeugs; und

Figur 4 ist ein perspektivisches Teildiagramm eines Bereichs einer spritzgegossenen Leiterplatte, bei der das Werkzeug nach Fig. 3 nützlich ist.

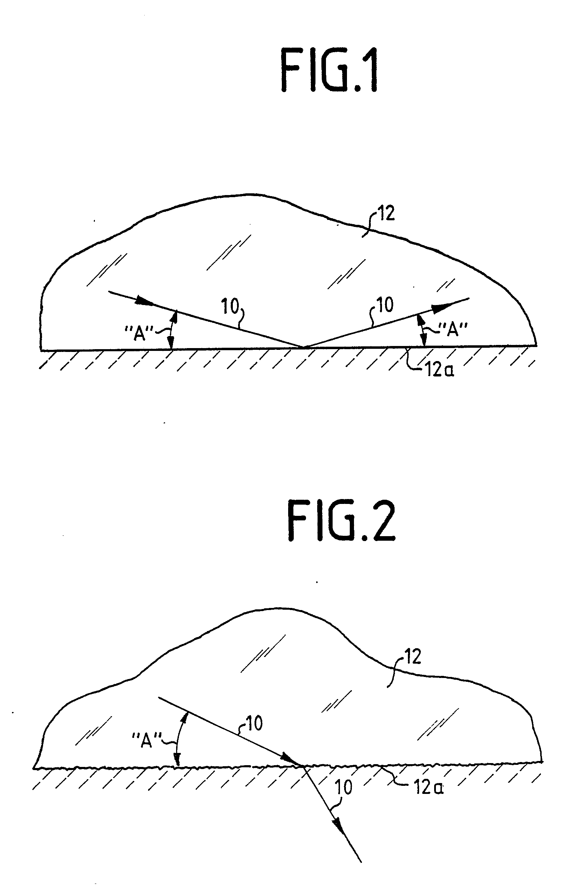

Unter Bezug zunächst auf die Figuren 1 und 2 wird ein in einem Körper 12 aus optisch transparentem Material laufender Lichtstrahl 10 gezeigt, wie er unter einem Winkel "A" auf eine Fläche 12a des Körpers auffällt. Falls, wie in Fig. 1 gezeigt, die Fläche 12a glatt ist, wird der Lichtstrahl, falls er unter einem relativ kleinen Winkel einfällt, im Innern des Körpers unter dem entsprechenden Winkel "A" wie gezeigt totalreflektiert. Wenn andererseits die Fläche 12a rauh ist, wie in Fig. 2 gezeigt, wird der unter dem Winkel "A" einfallende Strahl 10 im Innern nicht totalreflektiert, sondern wird an der Fläche 12a gebrochen und läuft von der Fläche 12a nach außen.

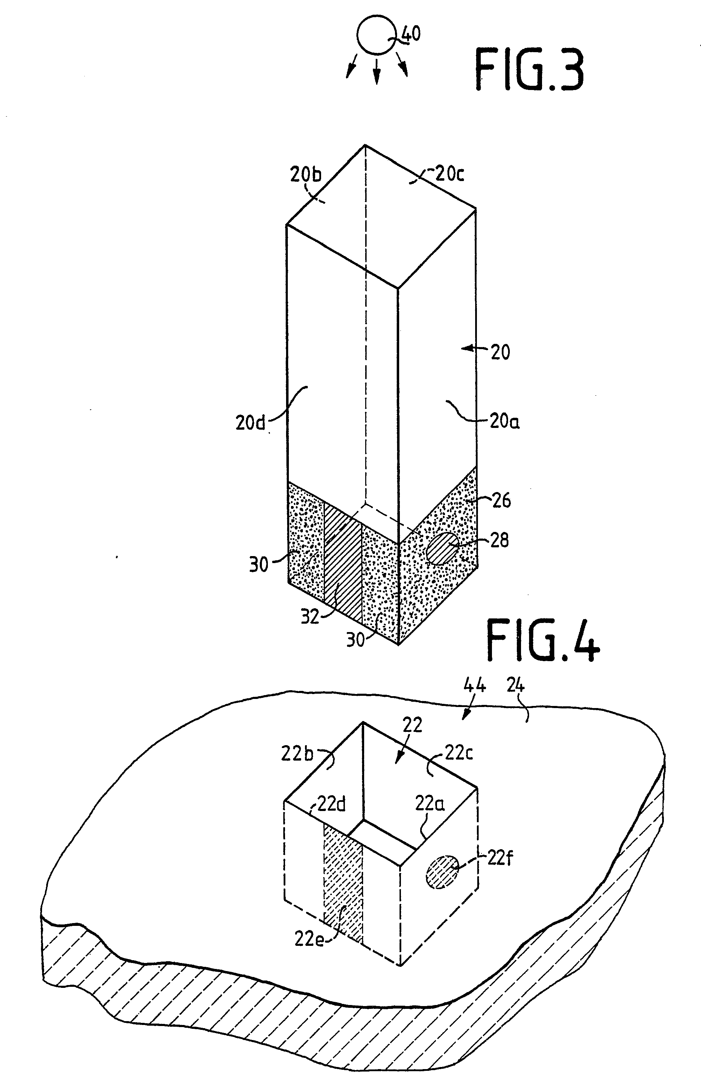

Fig. 3 zeigt ein Werkzeug in der Form eines rechteckigen, prismatischen Körpers aus optisch transparentem Material, wie z.B. Glas. Das Werkzeug is dafür ausge legt, Licht selektiv auf die Fläche eines Hohlraums 22 zu richten, der in der Fläche 24 einer Spritzgußleiterplatte 44 ausgebildet ist. Der Hohlraum 22 hat einen rechteckigen Querschnitt entsprechend dem rechteckigen Querschnitt des Werkzeugs 20. Der Hohlraum weist vier Seitenwandflächen 22a, 22b, 22c und 22d auf. Für den Zweck des vorliegenden Beispiels wird angenommen, daß es gewünscht ist, alle Flächen 22a, 22b, 22c und 22d zu bestrahlen, außer dem streifenförmigen Bereich 22e auf der Fläche 22d und dem kreisförmigen Bereich 22f auf der Fläche 22a.

Durch die vorliegende Erfindung wird Licht von einer Lichtquelle 40, wie z.B. einer Ultraviolettlichtquelle, am oberen Ende in Längsrichtung in das Werkzeug 20 gerichtet, wie in Fig. 3 gezeigt, wobei das untere Ende passend im Hohlraum 22 aufgenommen ist und wobei die unteren Bereiche der Seitenflächen des Werkzeugs dicht benachbart zu den betreffenden Bereichen der Flächen 22a, 22b, 22c und 22d des Hohlraums 22 angeordnet sind. Über den größten Teil seiner Außenfläche hat das Werkzeug 20 eine glatte Fläche, die jedoch insoweit optisch undurchsichtig ist, was Lichttransmission außerhalb des Werkzeugs anbetrifft, und zwar wegen der inneren Reflexion des Lichts von der Quelle 40, welches in Längsrichtung in das Werkzeug gerichtet wird. Die vier Seitenflächen 20a, 20b, 20c und 20d sind dagegen untere Bereiche, die benachbart zu den Flächen 22a, 22b, 22c bzw. 22d des Hohlraums 22 liegen, wenn das Werkzeug im Hohlraum 22 positioniert wird, und die derart behandelt sind, daß Lichttransmission zu den Flächen 22a, 22b, 22c und 22d wie gefordert gegeben ist. Insbesondere hat die Fläche 20a, die bei Benutzung des Werkzeugs benachbart sur Fläche 22a gebracht wird, einen aufgerauhten Bereich 26, in dessen Zentrum ein undurchsichtiger, kreisförmiger Bereich 28 vorgesehen ist, der bei Benutzung des Werkzeugs benachbart zu einem entsprechenden Bereich 22f der Fläche 22a eines Hohlraums 22 gebracht wird. Die unteren Bereiche der Flächen 20c und 20b werden aufgerauht, falls sie bei Benutzung des Werkzeugs benachbart zu den Flächen 22c und 22b sein sollen. In ähnlicher Weise wird der untere Teil 30 der Fläche 20b, wo diese benachbart zu Fläche 22ds des Hohlraums 22 sein soll, über einen Bereich 30 aufgerauht, außer einem streifenförmigen Bereich 32, der gegen den entsprechend geformten Bereich 22e der Fläche 22d positioniert werden soll.

In Benutzung wird dann bei in den Hohlraum 22, wie beschreiben, eingeführtem Werkzeug 20 Ultraviolettlicht von der Lichtquelle 40 in Längsrichtung des Werkzeugs gerichtet, und wegen der Aufrauhung der Bereiche 26 und 30 und der unteren Bereiche der Flächen 20c, 20b wird Licht vom Werkzeug über diese Bereiche emittiert und fällt auf die Flächen 22a, 22b, 22c und 22d auf. Licht wird jedoch vom Erreichen des Bereich 22f wegen der Undurchsichtigkeit des Bereichs 28 am Werkzeug 20 gehindert und wird in ähnlicher Weise vom Erreichen des Bereichs 22e wegen der Undurchsichtigkeit des Bereichs 32 gehindert.

Dadurch kann die Oberfläche der Leiterplatte 44 am Hohlraum 22 mit einer geeigneten, auf Ultraviolettlicht empfindlichen Substanz über einer darunterliegenden Kupferkaschierung beschichtet sein, wodurch bei Belichtung der Flächen 22a, 22b, 22c und 22d, wie beschrieben, die Bereiche 22f und 22e von der Belichtung ausgenommen sind. Somit können in einem folgendem Ätzvorgang die Bereiche der Flächen 22a, 22b, 22c und 22d, auf die Licht gerichtet wurde, weggeätzt werden, wobei Kupfer nur in den Bereichen 22e und 22f übriggelassen wird. Diese Bereiche können z.B. elektrische Kontakte für die Leiterplatte 44 aufweisen.

Durch Verwendung der beschriebenen Anordnungen können auch andere Werkzeuge als das beschriebene in Prismaform benutzt werden, z.B. geformt wie gewünscht, um selektives Aufbringen von Licht auf diverse Hohlräume oder andere komplex geformte Bereiche der Fläche der Leiterplatte 44 zu erlauben.

Während in der beschreibenen Ausführungsform Bezug auf die Verwendung einer Quelle 40 für Ultraviolettlicht genommen wurde, kann die Erfindung, wo angemessen, auch durch Verwendung anderer Quellen elektromagnetischer Strahlung verwirklicht werden, insbesondere wo die empfindliche Beschichtung der Leiterplatte auf Strahlung von derartigen anderen Quellen empfindlich ist. Im allgemeinen werden beim beschriebenen Verfahren Quellen von elektromagnetischer Strahlung mit optischen oder nahezu optischen Wellenlängen verwendet.

Der beschriebene Aufbau wurde nur beispielhaft zu Erläuterung dargestellt, und viele Änderungen und Variationen können hieran ausgeführt werden, ohne vom Geist und Umfang der Erfindung abzuweichen, welche jedes hierin offenbarte neue Merkmal oder jede neue Kombination von Merkmalen einschließt.

## Ansprüche

1. Verfahren zum selektiven Richten elektromagnetischer Strahlung auf eine vorgegebene Stelle (z.B. Flächenbereiche 22d oder 22a, außer den Bereichen 22e oder 22f) eines Gegenstands (z.B. einer Leiterplatte (44)), dadurch gekennzeichnet, daß die elektromagnetische Strahlung in ein Werkzeug in Form eines Körpers aus im wesentlichen für die elektromagnetische Strahlung transparentem Material gestrahlt wird, wobei die Oberfläche des Körpers über einen ersten, benachbart zur besagten Stelle des Gegenstands angeordneten Bereich (z.B. 26 oder 30) im Vergleich zu einem benachbarten, zweiten Bereich (z.B. Bereich 28 oder 32) der Körperoberfläche verändert wird, wobei die in den Körper gestrahlte elektromagnetische Strahlung selektiv von dem ersten Bereich emittiert wird und an besagter Stelle auf den Gegenstand auftrifft.

2. Verfahren nach Anspruch 1,
dadurch gekennzeichnet, daß der Körper an besagtem ersten Bereich mit einer aufgerauhten Oberfläche ausgebildet ist.

3. Verfahren nach Anspruch 1 oder 2,
dadurch gekennzeichnet, daß der zweite Bereich (28 und 32) undurchsichtig ist, um den Austritt elektromagnetischer Strahlung zu verhindern, und/oder glatt oder poliert und so angeordnet ist, daß die in den Körper eintretende Strahlung im Innern totalreflektiert wird.

4. Verfahren zum Bilden eines elektrisch leitenden Bereichs (22e, 22f) auf einer Leiterplatte durch einen Belichtungsvorgang eines ausgewählten Bereichs einer ersten Schicht von auf elektromagnetische Strahlung empfindlichen Materials mit elektromagnetischer Strahlung, um deren physikalische Eigenschaften zu ändern, dann Entfernen entweder der belichteten oder der nicht belichteten Bereiche der ersten Schicht und Behandeln der Platte in einem Vorgang, bei dem eine Kupferschicht unter der ersten Schicht an den entfernten Bereichen der ersten Schicht entfernt wird und unter dem nicht entfernten Bereich der ersten Schicht beibehalten wird, um den elektrisch leitenden Bereich zu bilden, dadurch gekennzeichnet, daß die selektive Beaufschlagung mit Licht durch das in einem der Ansprüche 1 bis 3 beanspruchten Verfahren bewirkt wird.

6. Verfahren nach einem der vorhergehenden Ansprüche,
dadurch gekennzeichnet, daß die elektromagnetische Strahlung Licht mit optischer oder nahezu optischer Wellenlänge umfaßt.

7. Verfahren nach Anspruch 6,
dadurch gekennzeichnet, daß das Licht Ultraviolettlicht ist.

8. Leiterplatte, hergestellt nach dem Verfahren nach Anspruch 4 oder 5.

# FIG.1

# FIG.2

FIG.3

FIG.4